Europäisches Patentamt

European Patent Office

Office européen des brevets

(19)

(11) **EP 1 252 716 B1**

(12) **EUROPÄISCHE PATENTSCHRIFT**

(45) Veröffentlichungstag und Bekanntmachung des Hinweises auf die Patenterteilung:
**06.08.2003 Patentblatt 2003/32**

(21) Anmeldenummer: **00988598.9**

(22) Anmeldetag: **14.11.2000**

(51) Int Cl.⁷: **H03M 13/45**, H04L 1/00

(86) Internationale Anmeldenummer:
**PCT/DE00/03998**

(87) Internationale Veröffentlichungsnummer:
**WO 01/043294 (14.06.2001 Gazette 2001/24)**

(54) **VERFAHREN UND ANORDNUNG ZUR DEKODIERUNG VON INFORMATIONEN**

METHOD AND CONFIGURATION FOR DECODING INFORMATION

PROCEDE ET SYSTEME POUR LE DECODAGE D'INFORMATIONS

(84) Benannte Vertragsstaaten:
**DE FR GB**

(30) Priorität: **08.12.1999 DE 19959178**

(43) Veröffentlichungstag der Anmeldung:
**30.10.2002 Patentblatt 2002/44**

(73) Patentinhaber: **SIEMENS AKTIENGESELLSCHAFT 80333 München (DE)**

(72) Erfinder: **XU, Wen 82008 Unterhaching (DE)**

(56) Entgegenhaltungen:
**WO-A-98/58467**

• **HAGENAUER J: "SOURCE-CONTROLLED CHANNEL DECODING" IEEE TRANSACTIONS ON COMMUNICATIONS,IEEE INC. NEW YORK,US, Bd. 43, Nr. 9, 1. September 1995 (1995-09-01), Seiten 2449-2457, XP000525669 ISSN: 0090-6778**
• **CROZIER S ET AL: "Performance and complexity comparison of block turbo-codes, hyper-codes and tail-biting convolutional codes" PROC. 19TH BIENNIAL QUEEN'S SYMPOSIUM ON COMMUNCATIONS, Juni 1998 (1998-06), Seiten 84-88, XP000989497 Kingston, ON, Canada**
• **RUSCITTO A ET AL: "CHANNEL DECODING USING RESIDUAL INTRA-FRAME CORRELATION IN A GSM SYSTEM" ELECTRONICS LETTERS,IEE STEVENAGE,GB, Bd. 33, Nr. 21, 9. Oktober 1997 (1997-10-09), Seiten 1754-1755, XP000752306 ISSN: 0013-5194**

**EP 1 252 716 B1**

**Beschreibung**

Die Erfindung betrifft ein Verfahren und eine Anordnung zur Decodierung von Informationen, die von einer Informationsquelle ausgegeben werden, codiert werden und über einen mit Störungen behafteten Übertragungskanal übertragen werden.

Quellensignale wie Sprach- oder Videosignale beinhalten in der Regel statistische Redundanz. Durch eine Quellencodierung kann diese Redundanz verringert werden, so daß eine effiziente Übertragung bzw. Speicherung des Quellensignals ermöglicht wird. Um empfangsseitig Kanalstörungen rückgängig zu machen, ist es bekannt, sendeseitig gezielt Redundanz durch Kanalcodierung hinzuzufügen.

Aufgrund der unvollständigen Kenntnisse über die Quellensignale oder Einschränkungen bei der Komplexität des Codierverfahrens ist die Quellencodierung üblicherweise nur suboptimal realisierbar, d.h. in komprimierten Daten ist noch gewisse Redundanz vorhanden. Diese Restredundanz kann als a priori-/a posteriori-Informationen bei der sogenannten quellengesteuerten oder gemeinsamen Quellen- und Kanaldecodierung ausgenutzt werden, um weitere Bitfehler zu korrigieren. Dabei wird der Decodiervorgang des Kanaldecodierers sowohl durch die übertragenen Informationen als auch durch a priori-/a posteriori-Informationen über den wahrscheinlichen Wert einiger wichtiger Quellenbits gesteuert. Zur Schätzung der a priori-/a posteriori-Informationen kann man beispielsweise ein auf einem Kalman-Filter basierendes Verfahren verwenden.

Es stellte sich allerdings heraus, daß die Verwendung dieser Restredundanz, also der a priori-/a posteriori-Informationen, bei der Kanaldecodierung im Zuge einer quellengesteuerten Kanaldecodierung zu Decodierfehlern führen kann. So führt die Heranziehung der a priori-/a posteriori-Informationen zu einer Verschlechterung der Decodierung, wenn der zu übertragende Wert einer Bitstelle von der statistischen a priori-/a posteriori-Informationen über den Wert dieser Bitstelle abweicht. Das Dokument Hagenauer J: "Source-Controlled Channel Decoding", IEEE Transactions on Communications, offenbart ein Verfahren zur quellengesteuerten Kanaldecodierung von Daten im Rahmenformat. Der Erfindung liegt daher die Aufgabe zugrunde, eine Decodierung von Informationen unter Heranziehung von statistischen Informationen über die Informationsquelle mit zufriedenstellenden Decodierergebnissen zu ermöglichen.

Diese Aufgabe wird durch die Merkmale der unabhängigen Ansprüche gelöst. Vorteilhafte und zweckmäßige Weiterbildungen ergeben sich aus den abhängigen Ansprüchen.

Die Erfindung basiert also auf dem Prinzip, zur quellengesteuerten Kanaldecodierung den Einfluß der a priori- oder a posteriori-Informationen über die Quellenstatistik in Abhängigkeit von der Zuverlässigkeit der Decodierung zu modifizieren.

Es werden also zur Entscheidung über einen, einer Bitstelle zuzuordnenden Wert neben den übertragenen Informationen statistische Informationen über die Informationsquelle herangezogen, wobei der Einfluß der statistischen Informationen über die Informationsquelle auf die Entscheidung in Abhängigkeit von der Zuverlässigkeit der Decodierung modifiziert wird.

Beispielsweise kann ein Wert ermittelt werden, der die Zuverlässigkeit der Decodierung charakterisiert, mit dem die statistischen Informationen über die Informationsquelle gewichtet werden, insbesondere multipliziert werden.

Dadurch ist es möglich, je nach aktueller Zuverlässigkeit der Decodierung den statistischen Informationen über die Informationsquelle einen größeren oder kleineren Einfluß auf die Entscheidung über den einer Bitstelle zuzuordnenden Wert einzuräumen.

Eine Weiterbildung der Erfindung sieht vor, daß die Decodierung, insbesondere die Kanaldecodierung, einen Soft-Output oder Soft-Ausgang aufweist, der ein Maß für die Zuverlässigkeit der Decodierung darstellt. Der Wert des Soft-Outputs kann dann direkt oder indirekt den Einfluss der statistischen Informationen über die Informationsquelle auf die Decodierung modifizieren. Einem Fachmann sind Soft-Output-Decodierverfahren als solche bekannt, wie beispielsweise Soft-Output-Viterbi-Algorithmen oder Soft-Output-Maximum-Likelihood-Decodierverfahren.

Zur Decodierung können auch mehrere aufeinanderfolgende Decodierschritte durchgeführt werden. Eine andere Ausgestaltung der Erfindung sieht daher vor, daß ein erster Decodierschritt ohne Heranziehung statistischer Informationen über die Informationsquelle durchgeführt wird, ein zweiter Decodierschritt unter Heranziehung statistischer Informationen über die Informationsquelle durchgeführt wird, und der Einfluss der statistischen Informationen über die Informationsquelle auf die Decodierung in Abhängigkeit von der Zuverlässigkeit der Decodierung im ersten Decodierschritt modifiziert wird.

Dabei ist es möglich, daß der erste Decodierschritt dieselbe Bitstelle betrifft wie der zweite Decodierschritt, oder der erste Dekodierschritt eine erste Bitstelle betrifft, und der zweite Dekodierschritt eine zweite Bitstelle, beispielsweise eines nachfolgenden Rahmens, betrifft. Insbesondere durch das Einbringen in ein iteratives Decodierverfahren, wie beispielsweise eine Turbo-Decodierung, führt dies, wie aufwendige Simulationen zeigen, zu guten Decodierergebnissen, ohne den Rechenaufwand für die Decodierung wesentlich zu erhöhen.

Schließlich sieht eine Weiterbildung der Erfindung vor, dass der Einfluss der statistischen Informationen über die Informationsquelle auf die Decodierung bei relativ geringer Zuverlässigkeit der Dekodierung relativ groß ist, wohingegen er bei relativ großer Zuverlässigkeit der Dekodierung relativ klein ist.

Im folgenden werden Ausführungsbeispiele der Erfindung an Hand der Zeichnungen erläutert. Darin zeigen:

Figur 1    ein Blockdiagramm einer Datenübertragungskette,

Figur 2    zwei zu übertragende Daten-Rahmen.

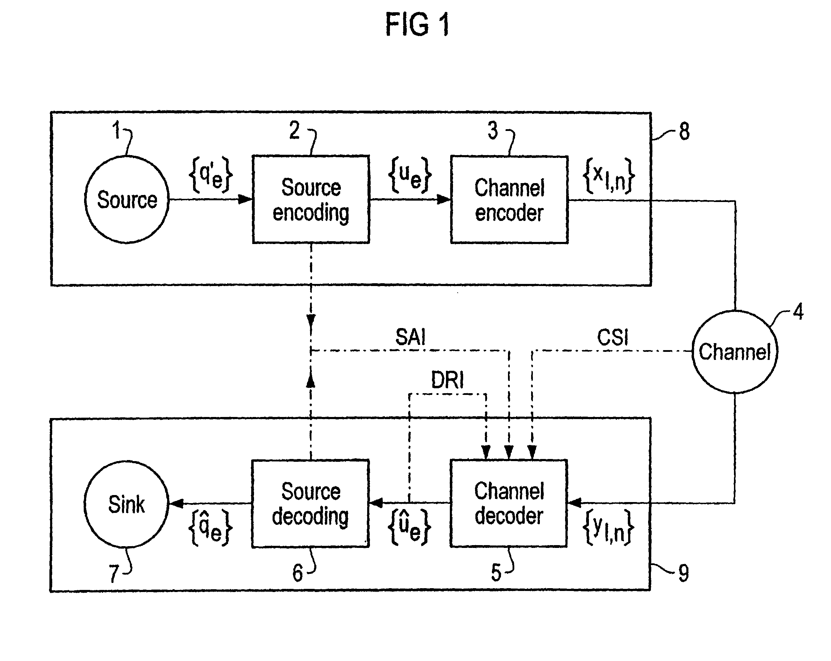

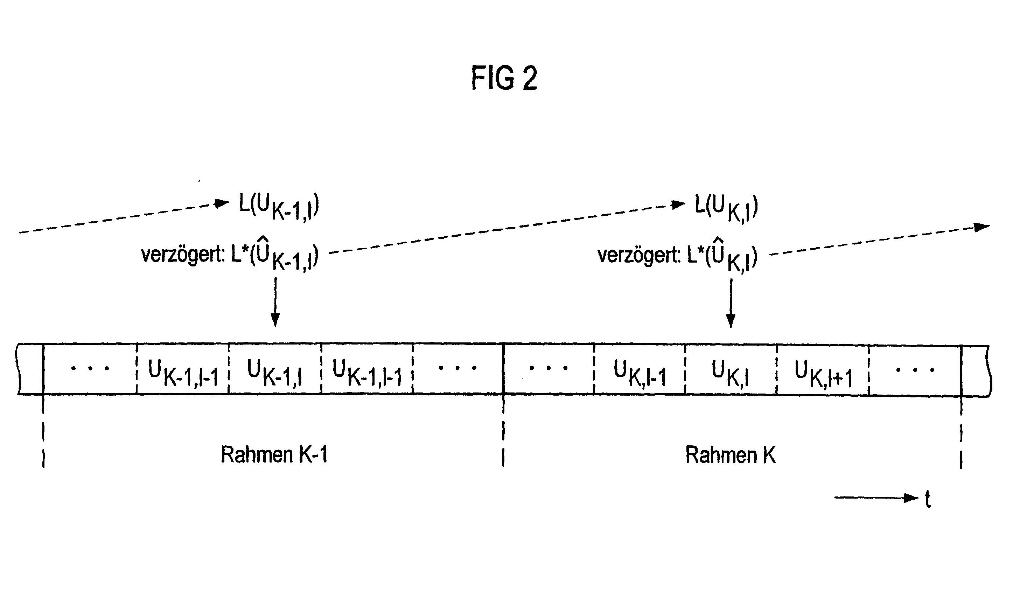

Figur 1 zeigt ein Blockdiagramm mit wesentlichen Funktionseinheiten für eine Datenübertragung. Dabei wird auch die Übertragung eines Rahmens k beschrieben, wobei auf den die natürlichen Zahlen annehmende Index k zur besseren Übersicht in Figuren und folgenden Erläuterungen nicht Bezug genommen wird, wenn es zum Verständnis der Ausführungsbeispiele nicht erforderlich ist. Für die Erfindung ist die Übertragung in Rahmen keine notwendige Voraussetzung. Der Aufbau des Rahmens k wird unten anhand der Figur 2 erläutert.

Eine in einem Sender 8 durch eine Informationsquelle 1 erzeugte Quellsymbolfolge $\{q_{l'}\}$ besteht aus Quellsymbolen $q_{l'}$, die abhängig von den zu sendenden Informationen z.B. die Werte "+1" und "-1" haben. Der Index 1' läuft für die im Rahmen k übertragenen Quellsymbole $q_{l'}$ von 0 bis L'-1, wobei L' die Anzahl von Quellsymbolen $q_{l'}$ je Rahmen k ist. Die Quellsymbolfolge $\{q_{l'}\}$ wird durch einen Quellencodierer 2 komprimiert, z.B. mit einem GSM-Fullrate-Sprachcodierer. Dabei wird eine quellencodierte Folge $\{u_l\}$ aus quellencodierten Symbolen $u_l$ erzeugt. Die quellencodierten Symbole $u_l$ haben entweder den Wert "+1" oder "-1". Der Index 1 läuft innerhalb eines Rahmens von 0 bis L-1, wobei L die Anzahl von quellencodierten Symbolen $u_l$ in einem Rahmen ist. Dabei ist L' üblicherweise größer als L.

Die quellencodierte Folge $\{u_l\}$ wird dann in einem Kanalcodierer 3 gegen Kanalstörungen codiert, wobei z.B. ein Faltungscode verwendet wird. Dabei entsteht eine kanalcodierte Folge $\{x_{l,n}\}$ aus Codeworten $x_l$. Innerhalb der Codeworte $x_l$ werden die Bitstellen durch den Index n bezeichnet, der innerhalb eines Codewortes $x_l$ von Null bis N-1 läuft, wobei N die Anzahl der Bitstellen in einem Codewort $x_l$ ist. Die Bitstellen $x_{l,n}$ der Codeworte $x_l$ haben wiederum entweder den numerischen Wert "+1" oder "-1". Die kanalcodierte Folge $\{x_{l,n}\}$ wird in einem nicht dargestellten Modulator weiterverarbeitet und anschließend über eine Übertragungsstrecke 4 übertragen. Die Übertragungsstrecke ist ein Funkkanal oder eine Übertragungsleitung oder auch ein Speichermedium, von dem Daten gelesen werden. Bei der Übertragung über einen Funkkanal treten Störungen auf, z.B. Fading, beschrieben durch einen Fadingfaktor $a_k$, und Rauschen, beschrieben durch den Rauschfaktor $N_0$.

Die Übertragungsstrecke 4 liegt zwischen dem Sender 8 und einem Empfänger 9. Der Empfänger 9 enthält gegebenenfalls eine nicht dargestellte Antenne zum Empfang der über die Übertragungsstrecke 4 übertragenen Signale, eine Abtasteinrichtung, einen Demodulator zum Demodulieren der Signale und einen Entzerrer zum Eliminieren der Intersymbolstörungen. Diese Einrichtungen wurden ebenfalls aus Vereinfachungsgründen in Figur 1 nicht dargestellt. Der Entzerrer gibt Empfangswerte $y_{l,n}$ einer Empfangsfolge $\{y_{l,n}\}$ aus. Die Empfangswerte $y_{l,n}$ haben aufgrund der Störungen bei der Übertragung über die Übertragungsstrecke 4 Werte, die von "+1" und "-1" abweichen können, z.B. "+0,2" oder "-3,7".

Die Empfangswerte $y_{l,n}$ werden in einem Kanaldecodierer 5 weiter bearbeitet. Zur Auswertung der Empfangswerte $y_{l,n}$ kann auch ein Maximum-Aposteriori-Wahrscheinlichkeitsalgorithmus oder Maximum-Likelihood-Algorithmus verwendet werden. Dabei wird eine über eine Übertragungsstrecke übertragene Datenfolge mit einer Referenzfolgen s verglichen, und die Referenzfolge s bestimmt, die mit der größten Wahrscheinlichkeit zu der gesendeten Datenfolge gehört. Maximum-Aposteriori-Wahrscheinlichkeit bedeutet, daß die Referenzfolge s gewählt wird, für die die Wahrscheinlichkeit P (s|y) maximal wird, wobei y die empfangene Datenfolge ist. Maximum-Likelihood bedeutet, daß die Referenzfolge s gewählt wird, für die die Wahrscheinlichkeit P (y|s) maximal wird. Eine Maximum-Likelihood-Decodierung kann beispielsweise durch einen an sich bekannten Viterbi-Algorithmus realisiert werden. Die vom Kanalcodierer 3 durchgeführte Faltungscodierung kann so im Kanaldecodierer 5 wieder rückgängig gemacht werden, wobei Übertragungsfehler korrigiert werden sollen.

Der Kanaldecodierer 5, der durch eine Prozessoreinrichtung, wie beispielsweise einen Digitalen Signalprozessor gebildet sein kann, erzeugt eine empfangene quellencodierte Folge $\{û_l\}$ aus quellencodierten bzw. kanalcodierten Empfangssymbolen $û_l$. Zu jedem quellencodierten Empfangssymbol $û_{k-1,l}$ gehört ein beobachteter Zuverlässigkeitswert $L^*(û_{k-1,l})$, der eine sogenannte Soft-Ausgabe des Kanaldecodierers 5 ist. Dieser Zuverlässigkeitswert $L^*(û_{k-1,l})$ ist ein Maß für die Zuverlässigkeit, mit der das quellencodierte Empfangssymbol $û_l$ durch den Kanaldecodierer 5 bestimmt werden konnte.

Allgemein kann für eine binäre Zufallsvariable mit den Elementen {+1; -1} ein logarithmisches Wahrscheinlichkeitsverhältnis L oder L* folgendermaßen definiert sein:

$$L(u_l)=\log\frac{P(u_l=+1)}{P(u_l=-1)}=\log\frac{l\text{-}p}{p} \qquad (0).$$

$P(u_l=-1)=p$ ist die Wahrscheinlichkeit dafür, daß $u_l$ den Wert "-1" hat. $P(u_l=+1)=1\text{-}p$ ist dagegen die Wahrscheinlichkeit,

daß $u_l$ den Wert "+1" hat. Die Abkürzung "log" kennzeichnet den natürlichen Logarithmus. Dieser Wert wird auch als Softwert oder Soft-Output-Wert bezeichnet. Es kann sich dabei um einen geschätzten Wert L, der a priori oder a posteriori bestimmt wird und statistische Informationen über die Informationsquelle beschreibt, handeln oder um einen beobachteten Wert L* handeln, der die Zuverlässigkeit des durchgeführten Decodierschritts beschreibt.

Gemäß der Definition (0) sind die statistischen Informationen über die Informationsquelle L oder der beobachtete Zuverlässigkeitswert L* durch eine reelle Zahl im Bereich von $[-\infty, +\infty]$ bezeichnet. Klassifiziert man $u_l$ an Hand der Werte $L(u_l)$ als "+1" oder "-1", dann gibt das Vorzeichen $sign(L(u_l))$ die sogenannte Hard-Entscheidung und der Betrag $|L(u_l)|$ die geschätzte a priori- oder a posteriori-Information oder die Zuverlässigkeit der Entscheidung an.

Die quellencodierten Empfangssymbole $\hat{u}_{k-1,l}$ und/oder die beobachteten Zuverlässigkeitswerte $L^*(\hat{u}_{k-1,l})$ werden in einen Quellendecodierer 6 eingegeben, der die quellencodierten Empfangssymbole $\hat{u}_l$ decomprimiert, wobei eine Quellsymbolfolge $\{q_{l'}\}$ aus empfangenen Quellsymbolen $q_{l'}$ entsteht.

Bei der Faltungsdecodierung wird z.B. der bekannte Viterbi-Algorithmus verwendet. Zur Durchführung des Viterbi-Algorithmus wird dem Kanaldecodierer 5 gegebenenfalls auch eine Kanalzustandsinformation CSI $Lc_{l,n}$ zugeführt. Bei der Durchführung des Viterbi-Algorithmus im Kanaldecodierer 5 kann unter Einbeziehung von statistischen Informationen über die Informationsquelle SAI eine sogenannte Metrik $M_l^{(m)}$ des Pfades m für die Bitstelle 1 nach der folgenden Formel berechnet:

$$M_l^{(m)} = \dot{M}_{l-1}^{(m)} + \sum_{n=0}^{N-1} \hat{x}_{l,n}^{(m)} Lc_{l,n} y_{l,n} + \hat{u}_l^{(m)} L(u_{k,l}) \qquad (1),$$

wobei $M_{l-1}^{(m)}$ die alte Metrik des Pfades m ist, d.h. für die Bitstelle 1-1, $\hat{x}_{l,n}^{(m)}$ die Bits des zum Pfad m und zur Bitstelle 1 gehörenden Codewortes sind, $\hat{u}_l^{(m)}$ das zum Codewort $x_l^{(m)}$ gehörende decodierte Symbol und $L(u_{k,l})$ statistische Informationen über die Informationsquelle sind, welche ein Maß für diejenige Wahrscheinlichkeit sind, daß das quellencodierte Symbol $u_l$ gleich "-1" ist.

Die statistischen Informationen über die Informationsquelle SAI, welche insbesondere durch $L(u_{k,l})$ gebildet sein können, können je nach Ausführungsvariante "a priori" vor der Decodierung beispielsweise sendeseitig ermittelt werden und an den Empfänger übermittelt und abgespeichert werden oder "a posteriori" nach oder bei der Decodierung empfangsseitig beispielsweise mittels eines Kalman-Filters ermittelt werden. Ein derartiges Verfahren ist z.B. aus der PCT-Veröffentlichung mit Offenlegungsnummer WO98/59423, insbesondere aus der Beschreibung zu den Figuren 3 und 4, bekannt.

Die Kanalzustandsinformation CSI = $Lc_{l,n}$ kann implizit bestimmt werden, indem eine sogenannte Kanal-Soft-Ausgabe ermittelt wird, die dem Produkt aus der Kanalzustandsinformation CSI = $Lc_{l,n}$ und dem jeweiligen Empfangswert $y_{l,n}$ entspricht. Für die Kanal-Soft-Ausgabe gilt die Beziehung:

$$L_c y = L(x/y) - L(x) \qquad (2),$$

worin $L(x/y)$ angibt, mit welcher Wahrscheinlichkeit an der jeweiligen Bitstelle des Codewortes der Wert x auftritt, wenn der Empfangswert y empfangen wurde, und $L(x)$ angibt, wie sicher der Wert x bestimmt werden kann. Für einen sogenannten Gauß-/Fading-Kanal gilt $L_C = 4a E_S/N_0$, wobei a der Fadingfaktor und $E_S/N_0$ das Signal-Rausch-Verhältnis sind.

Figur 2 zeigt zwei Rahmen, nämlich den aktuellen Rahmen k und den vorherigen Rahmen k-1, aus quellencodierten Symbolen $u_l$. Zu jedem Rahmen k, k-1 gehören L quellencodierte Empfangssymbole $u_l$, so daß der Index 1 von 0 bis L-1 läuft. Zwischen bestimmten quellencodierten Symbolen, z.B. dem Symbol $u_{k,l}$ und $u_{k-1,l}$ aufeinanderfolgender Rahmen k-1, k existiert oft eine ausgeprägte Korrelation. Diese Korrelation kann genützt werden, um "a posteriori" statistische Informationen über die Informationsquelle $L(u_{k,l})$ zu ermitteln.

Werden die Metrikinkremente $M_l^{(m)}$ für die zum Empfangssymbol $\hat{u}_{k-1,l}$ gehörenden Zustände berechnet, so werden jeweils die statistischen Informationen über die Informationsquelle $L(u_{k-1,l})$ gemäß Formel (1) berücksichtigt. Der Zuverlässigkeitswert $L^*(\hat{u}_{k-1,l})$ ist zu diesem Zeitpunkt noch nicht bekannt. Werden danach die Metriken $M_l^{(m)}$ für die zum Empfangssymbol $\hat{u}_{k,l}$ gehörenden Zustände ermittelt, so können aus dem zu diesem Zeitpunkt bekannten Zuverlässigkeitswert $L^*(\hat{u}_{k-1,l})$ "a posteriori" statistische Informationen über die Informationsquelle $L(u_{k,l})$ beispielsweise mittels eines Kalman-Filters berechnet werden.

Geht man nun von einem Fall aus, bei dem dieselbe Bitstelle innerhalb eines Rahmens in aufeinanderfolgenden Rahmen fast immer den Wert +1 aufweist, und bestimmt man _m Rahmen k die a priori-Information für $u_{k,l}$ aus den bereits decodierten Bits an derselben Bitstelle in vorangegangenen Rahmen, so ist die geschätzte a priori-Information $L(u_{k,l})>0$, d.h. $u_{k,l}$ ist mit größerer Wahrscheinlichkeit +1 als -1. Ist nun aber der gesendete Wert für diese Bitstelle -1, so hat die Heranziehung dieser apriori-Information zur Decodierung von $u_{k,l}$ einen negativen Einfluss auf das Decodierergebnis.

Daher wird diese a priori-Information gemäß einer Ausführungsvariante der Erfindung durch einen Wert, der die Zuverlässigkeit der Decodierung charakterisiert, modifiziert. So kann beispielsweise in Gleichung 1 die a priori-Information $L(u_{k,l})$ durch $(1-|m'(\hat{u}_k)|)L(u_{k,l})$ ersetzt werden, wobei

$$m'(\hat{u}_{k,l}) = \tanh\frac{\lambda L^*(\hat{u}_{k,l})}{2}$$

m' ist dabei ein Soft-Output-Wert, der von dem skalierten beobachteten Zuverlässigkeitswert $\lambda \boldsymbol{L^*(\hat{u}_k,l)}$ ($\lambda > 0$ ist ein Skalierungswert) der Bitstelle $\boldsymbol{\hat{u}_{k,l}}$ in einem vorhergehenden Decodierschritt abhängt. $\boldsymbol{L^*(\hat{u}_{k,l})}$ kann beispielsweise durch einen Soft-Output-Viterbi-Algorithmus oder einen MAP(maximum *a posteriori* probability)-Decodierer bestimmt werden. Dabei bestimmt

$$1-|m'(\hat{u}_{k,l})| = \frac{2}{1 + e\lambda|L^*(\hat{u}_{k,l})|}$$

die Unsicherheit des vorhergehenden Decodierschrittes. Die a priori-Information hat also einen großen Einfluß, wenn der vorhergehnden Decodierschritt relativ unzuverlässig ist ($|m'(\hat{u}_{k,l})| \ll 1$).

m' hängt dabei von der Zuverlässigkeit der Decodierung ab. Dabei kann die Zuverlässigkeit der Decodierung in einem dem aktuellen Decodierschritt vorhergehenden Decodierschritt bestimmt werden. Je nach Ausführungsvariante kann dabei der vorhergehende Decodierschritt dieselbe Bitstelle desselben Rahmens, eine vorhergehende Bitstelle desselben Rahmens, eine vorhergehenden Bitstelle eines vorhergehenden Rahmens, oder dieselbe Bitstelle eines vorhergehenden Rahmens - in Figur 2 dargestellt - betreffen.

Eine Ausführungsform der Erfindung sieht dabei vor, daß der zweite Decodierschritt nicht durchgeführt wird, wenn die Zuverlässigkeit der Decodierung im ersten Decodierschritt über einem vorgegebenen Schwellwert liegt, beispielsweise wenn |L*| größer als ein vorgegebener Schwellwert ist. Dies ermöglicht eine Verringerung des Decodieraufwandes.

Aufgrund der Aktualität der Zuverlässigkeitsinformation liefert die Decodierung insbesondere dann gute Decodierergebnisse, wenn - anders als in Figur 2 dargestellt - im zweiten Decodierschritt dieselbe Bitstelle desselben Rahmens wie im ersten Decodierschritt decodiert wird, jedoch unter oben erläuterter Ausnützung der im ersten Decodierschritt ermittelten Zuverlässigkeit der Decodierung. Dabei werden also für eine Bitstelle zwei oder bei Ausführungsvarianten sogar mehr als Decodierschritte durchgeführt.

Insbesondere kann zur Bestimmung der Zuverlässigkeit der Decodierung ein Soft-Output-Wert verwendet werden. Die Erfindung ist jedoch keinesfalls darauf beschränkt; vielmehr kann die Zuverlässigkeit der Decodierung auch durch andere, einem Fachmann als solche bekannte, Größen beschrieben werden, wie beispielsweise der Sprachrahmenfehlerdetektionsrate, die im Quellendecodierer bestimmt wird. Im ersten Decodierschritt werden dabei keine a priori-Informationen zur Decodierung herangezogen. Im zweiten Decodierschritt werden a priori-Informationen zur Decodierung herangezogen, allerdings in Abhängigkeit von der Zuverlässigkeit des ersten Decodierschrittes modifiziert.

Eine Ausführungsvariante der Erfindung sieht vor, daß auch schon im ersten Decodierschritt a priori-Informationen zur Decodierung herangezogen werden.

In den oben erläuterten Beispielen ist die Erfindung vor allem im Zusammenhang mit der Kanaldecodierung beschrieben. Die Erfindung ist aber keinesfalls darauf beschränkt. Vielmehr liegt es Rahmen fachmännischen Handelns, die Erfindung auch im Zusammenhang mit anderen Decodierarten zu verwenden. So kann beispielsweise ein Entzerrer, der z.B. bei Verwendung eines Viterbi-Algorithmus als Kanaldecodierer eines Rate-1 Codes betrachtet werden kann, ebenfalls durch die Erfindung verbessert werden. Ebenso kann die Erfindung zur Demodulation von, insbesondere codiert modulierten, Signalen herangezogen werden.

**Patentansprüche**

**1.** Verfahren zur Decodierung von Informationen, die von einer Informationsquelle (1) ausgegeben werden und codiert über einen mit Störungen behafteten Übertragungskanal (4) übertragen werden,

- bei dem neben den übertragenen Informationen (y,1,n) statistische Informationen (SAI) über die Informationsquelle herangezogen werden,

**dadurch gekennzeichnet, daß**

- der Einfluß der statistischen Informationen (SAI) über die Informationsquelle auf die Decodierung in Abhängigkeit von der Zuverlässigkeit (DRI) der Decodierung modifiziert wird.

2. Verfahren nach Anspruch 1, bei dem

- die Decodierung einen Soft-Output-Decodierschritt umfaßt, und der Wert des Soft-Output-Decodierschritts die Zuverlässigkeit (DRI) der Decodierung charakterisiert.

3. Verfahren nach einem der vorhergehenden Ansprüche,

- bei dem ein erster Decodierschritt und ein zweiter Decodierschritt durchgeführt wird, und
- bei dem in einem zweiten Decodierschritt die Decodierung mit statistischen Informationen (SAI) über die Informationsquelle (1) durchgeführt wird, wobei der Einfluß der statistischen Informationen (SAI) über die Informationsquelle auf die Decodierung in Abhängigkeit von der Zuverlässigkeit (DRI) der Decodierung im ersten Decodierschritt modifiziert wird.

4. Verfahren nach Anspruch 3,

- bei dem in dem ersten Decodierschritt die Decodierung ohne statistische Informationen (SAI) über die Informationsquelle (1) durchgeführt wird.

5. Verfahren nach einem der Ansprüche 3 oder 4,

- bei dem der zweite Decodierschritt nicht durchgeführt wird, wenn die Zuverlässigkeit der Decodierung im ersten Decodierschritt über einem vorgegebenen Schwellwert liegt.

6. Verfahren nach einem der vorhergehenden Ansprüche,

- bei dem der Einfluß der statistischen Informationen (SAI) über die Informationsquelle (1) auf die Decodierung mit abnehmender Zuverlässigkeit der Decodierung zunimmt.

7. Anordnung zur Decodierung von Informationen, die von einer Informationsquelle ausgegeben werden und codiert über einen mit Störungen behafteten Übertragungskanal übertragen werden, mit

- einem Decodierer (5), der derart eingerichtet ist, daß
- zur Decodierung neben den übertragenen Informationen statistische Informationen über die Informationsquelle herangezogen werden, und
- der Einfluß der statistischen Informationen über die Informationsquelle auf die Decodierung in Abhängigkeit von der Zuverlässigkeit der Decodierung modifiziert wird.

8. Anordnung nach Anspruch 7, bei der

- die Decodierung einen Soft-Output-Decodierschritt umfaßt, und der Wert des Soft-Output-Decodierschritts die Zuverlässigkeit der Decodierung charakterisiert.

9. Anordnung nach einem der Ansprüche 7 oder 8,

- bei der ein erster Decodierschritt und ein zweiter Decodierschritt durchgeführt wird, und
- bei der in einem zweiten Decodierschritt die Decodierung mit statistischen Informationen (SAI) über die Informationsquelle (1) durchgeführt wird, wobei der Einfluß der statistischen Informationen (SAI) über die Informationsquelle auf die Decodierung in Abhängigkeit von der Zuverlässigkeit (DRI) der Decodierung im ersten Decodierschritt modifiziert wird.

**10.** Anordnung nach Anspruch 9,

- bei dem in dem ersten Decodierschritt die Decodierung ohne statistische Informationen (SAI) über die Informationsquelle (1) durchgeführt wird.

**11.** Anordnung nach einem der Ansprüche 9 oder 10,

- bei welcher der zweite Decodierschritt nicht durchgeführt wird, wenn die Zuverlässigkeit der Decodierung im ersten Decodierschritt über einem vorgegebenen Schwellwert liegt.

**12.** Anordnung nach einem der Ansprüche 7 bis 11,

- bei welcher der Einfluß der statistischen Informationen über die Informationsquelle auf die Decodierung mit abnehmender Zuverlässigkeit der Decodierung zunimmt.

**Claims**

**1.** Method for decoding information that is output by an information source (1) and is transmitted in coded fashion via a transmission channel (4) affected by interference,

- in which alongside the transmitted information (y,I,n) statistical information (SAI) is applied via the information source,

**characterized in that**

- the influence of the statistical information (SAI) via the information source on the decoding is modified as a function of the reliability (DRI) of the decoding.

**2.** Method according to Claim 1, in which

- the decoding comprises a soft-output decoding step, and the value of the soft-output decoding step characterizes the reliability (DRI) of the decoding.

**3.** Method according to one of the preceding claims,

- in which a first decoding step and a second decoding step are carried out, and
- in which in a second decoding step the decoding is carried out with the aid of statistical information (SAI) via the information source (1), the influence of the statistical information (SAI) via the information source on the decoding being modified as a function of the reliability (DRI) of the decoding in the first decoding step.

**4.** Method according to Claim 3,

- in which the decoding is carried out in the first decoding step without statistical information (SAI) via the information source (1).

**5.** Method according to one of Claims 3 or 4,

- in which the second decoding step is not carried out when the reliability of the decoding in the first decoding step is above a prescribed threshold value.

**6.** Method according to one of the preceding claims,

- in which the influence of the statistical information (SAI) via the information source (1) on the decoding increases with decreasing reliability of the decoding.

**7.** Configuration for decoding information that is output by an information source and is transmitted in coded fashion via a transmission channel affected by interference, having

- a decoder (5) that is set up in such a way that
- alongside the transmitted information statistical information via the information source is applied for decoding purposes, and
- the influence of the statistical information via the information source on the decoding is modified as a function of the reliability of the decoding.

**8.** Configuration according to Claim 7, in which

- the decoding comprises a soft-output decoding step, and the value of the soft-output decoding step characterizes the reliability of the decoding.

**9.** Configuration according to one of Claims 7 or 8,

- in which a first decoding step and a second decoding step are carried out, and
- in which in a second decoding step the decoding is carried out with the aid of statistical information (SAI) via the information source (1), the influence of the statistical information (SAI) via the information source on the decoding being modified as a function of the reliability (DRI) of the decoding in the first decoding step.

**10.** Configuration according to Claim 9,

- in which the decoding is carried out in the first decoding step without statistical information (SAI) via the information source (1).

**11.** Configuration according to one of Claims 9 or 10,

- in which the second decoding step is not carried out when the reliability of the decoding in the first decoding step is above a prescribed threshold value.

**12.** Configuration according to one of Claims 7 to 11,

- in which the influence of the statistical information via the information source on the decoding increases with decreasing reliability of the decoding.

**Revendications**

**1.** Procédé pour le décodage d'informations qui sont délivrées par une source d'information (1), codé par un canal de transmission (4) affecté de perturbations,
dans lequel des informations statistiques (SAI) qui concernent la source d'information sont prises en compte en plus des informations transmises (y, I, n),
**caractérisé en ce que**
l'influence des informations statistiques (SAI) qui concernent la source d'information sur le décodage est modifiée en fonction de la fiabilité (DRI) du décodage.

**2.** Procédé selon la revendication 1, dans lequel le décodage comprend une étape de décodage à sortie logicielle, la valeur de l'étape de décodage à sortie logicielle caractérisant la fiabilité (DRI) du décodage.

**3.** Procédé selon l'une des revendications précédentes, dans lequel une première étape de décodage et une deuxième étape de décodage sont exécutées, et
dans lequel, dans une deuxième étape de décodage, le décodage est réalisé avec des informations statistiques (SAI) qui concernent la source d'information (1), l'influence des informations statistiques (SAI) qui concernent la source d'information sur le décodage étant modifiée en fonction de la fiabilité (DRI) du décodage dans la première étape de décodage.

**4.** Procédé selon la revendication 3, dans lequel le décodage de la première étape de décodage est exécuté sans les informations statistiques (SAI) qui concernent la source d'information (1).

**5.** Procédé selon l'une des revendications 3 ou 4, dans lequel la deuxième étape de décodage n'est pas exécutée lorsque la fiabilité du décodage dans la première étape de décodage est située au-dessus d'une valeur de seuil prédéterminée.

6. Procédé selon l'une des revendications précédentes, dans lequel l'influence des informations statistiques (SAI) qui concement la source d'information (1) sur le décodage augmente lorsque la fiabilité du décodage diminue.

7. Agencement pour le décodage d'informations qui sont émises par une source d'information, codées et transmises par un canal de transmission affecté de perturbations, avec :

   un décodeur (5) qui est agencé de telle sorte que pour le décodage, des informations statistiques qui concernent la source d'information sont prises en compte en plus des informations transmises, et l'influence des informations statistiques qui concernent la source d'information sur le décodage est modifiée en fonction de la fiabilité du décodage.

8. Agencement selon la revendication 7, dans lequel le décodage comprend une étape de décodage à sortie logicielle, la valeur de l'étape de décodage à sortie logicielle caractérisant la fiabilité du décodage.

9. Agencement selon l'une des revendications 7 ou 8, dans lequel une première étape de décodage et une deuxième étape de décodage sont exécutées, et
   dans lequel, dans une deuxième étape de décodage, le décodage est réalisé avec des informations statistiques (SAI) qui concernent la source d'information (1), l'influence des informations statistiques (SAI) qui concement la source d'information sur le décodage étant modifiée en fonction de la fiabilité (DRI) du décodage dans la première étape de décodage.

10. Agencement selon la revendication 9, dans lequel, dans la première étape de décodage, le décodage est exécuté sans informations statistiques (SAI) qui concernent la source d'information (1).

11. Agencement selon l'une des revendications 9 ou 10, dans lequel la deuxième étape de décodage n'est pas exécutée lorsque la fiabilité du décodage dans la première étape de décodage est située au-dessus d'une valeur de seuil prédéterminée.

12. Agencement selon l'une des revendications 7 à 11, dans lequel l'influence des informations statistiques qui concernent la source d'information sur le décodage augmente lorsque la fiabilité du décodage diminue.

# FIG 1

EP 1 252 716 B1

# FIG 2

$L(U_{K-1,I})$

verzögert: $L^*(\hat{U}_{K-1,I})$

$L(U_{K,I})$

verzögert: $L^*(\hat{U}_{K,I})$

| $\cdots$ | $U_{K-1,I-1}$ | $U_{K-1,I}$ | $U_{K-1,I-1}$ | $\cdots$ | $\cdots$ | $U_{K,I-1}$ | $U_{K,I}$ | $U_{K,I+1}$ | $\cdots$ |

Rahmen K-1

Rahmen K

$\longrightarrow t$

EP 1 252 716 B1